# EUROPEAN PATENT APPLICATION

(11) **EP 4 576 465 A1**
(43) Date of publication of application: **25.06.2025**
(21) Application number: 23219167.6
(22) Date of filing: 21.12.2023
(51) Int. Cl.: H02H 3/05, H02H 3/087, H02H 7/18

(54) **MAJORITY VOTING OVERCURRENT DETECTION SYSTEM**

(71) Applicant: Analog Devices International Unlimited Company, Limerick (IE)
(72) Inventor: KUSSTATSCHER, Benno, Co. Limerick (IE); SCHWOERER, Christoph Sebastian, Co. Limerick (IE); TREVISAN, Alessandro, Co. Limerick (IE); WHEELER, Erik Steven, Wilmington, 01887 (US); VAN VROONHOVEN, Caspar Petrus Laurentius, Co. Limerick (IE)
(74) Representative: Wallin, Nicholas James

(57) **Abstract**

An overcurrent detection system (100) for detecting an overcurrent in an electric vehicle energy storage system can include at least three overcurrent detection circuits (102, 104, 106, 108), where each of the at least three overcurrent detection circuits is configured to receive an indication of a battery current value corresponding to the same battery or battery cell and is configured to independently generate a respective overcurrent indication (134, 136, 138) when the battery current value exceeds a specified battery current threshold. The overcurrent detection system (100) can also include first voting circuitry (120), configured to receive the respective overcurrent indications from the at least three overcurrent detection circuits and configured to generate a first voted overcurrent signal (OCAL) when at least two of the respective overcurrent indications indicate that the battery current value exceeds the specified battery current threshold. The overcurrent detection system can also include second voting circuitry (122), configured similarly to the first voting circuitry.

## Description

### TECHNICAL FIELD

The present disclosure relates to overcurrent detection, and more particularly, but not by way of limitation, to overcurrent detection using multiple overcurrent detection circuits and a majority voting scheme.

### BACKGROUND

Overcurrent detection can be used to help protect systems from overcurrent. For example, overcurrent detection can help protect a conductor, energy source, or both from damage, such as can include damage due to overcurrent. Overcurrent detection can include determining an overcurrent condition using instantaneous current values, current values over one or more time periods, or both.

### SUMMARY

In an example, an overcurrent detection system for detecting an overcurrent in an electric vehicle energy storage system can include at least three overcurrent detection circuits, where each of the at least three overcurrent detection circuits is configured to receive an indication of a battery current value corresponding to the same battery or battery cell and is configured to independently generate a respective overcurrent indication when the battery current value exceeds a specified battery current threshold. The overcurrent detection system can also include first voting circuitry, configured to receive the respective overcurrent indications from the at least three overcurrent detection circuits and configured to generate a first voted overcurrent signal when at least two of the respective overcurrent indications indicate that the battery current value exceeds the specified battery current threshold. The overcurrent detection system can also include second voting circuitry, configured to receive the respective overcurrent indications from the at least three overcurrent detection circuits and configured to generate a second voted overcurrent signal when at least two of the respective overcurrent indications indicate that the battery current value exceeds the specified battery current threshold.

In an example, an overcurrent detection system for detecting an overcurrent in an electric vehicle energy storage system can include at least three overcurrent detection circuits, where each of the at least three overcurrent detection circuits is configured to receive an indication of a battery current value corresponding to the same battery or battery cell and is configured to independently generate an overcurrent indication when the battery current value exceeds a specified battery current threshold, and first pulse width modulation (PWM) circuitry, configured to receive the respective overcurrent indications from the at least three overcurrent detection circuits and configured to generate a first PWM signal including an indication of a number of the respective overcurrent indications indicating that the battery current value exceeds the specified battery current threshold.

In an example, a method for detecting an overcurrent in an electric vehicle energy storage system can include determining at least three overcurrent indications, using respective overcurrent detection circuits, where determining each of the at least three overcurrent indications includes receiving an indication of a battery current value corresponding to the same battery or battery cell, comparing the indication of a battery current value to a representation of a specified battery current threshold, and generating an overcurrent indication in response to the indication of a battery current value exceeding the representation of the specified battery current threshold. The method can also include determining at least two voted overcurrent signals, using respective voting circuitries, where determining each of the at least two voted overcurrent signals includes receiving the at least three overcurrent indications, and generating a voted overcurrent signal when at least two of the at least three overcurrent indications indicate that the battery current value exceeds the specified battery current threshold.

### BRIEF DESCRIPTION OF THE DRAWINGS

In the drawings, which may not be drawn to scale, like numerals may describe substantially similar components throughout one or more of the views. Like numerals having different letter suffixes may represent different instances of substantially similar components. The drawings illustrate generally, by way of example but not by way of limitation.
FIG. 1 is a schematic drawing of an example of portions of an overcurrent detection system.
FIG. 2A is a schematic drawing of an example of portions of an overcurrent detection system and an example of portions of an environment in which the overcurrent detection system can be used.
FIG. 2B is a schematic drawing of an example of portions of an overcurrent detection system and an example of portions of an environment in which the overcurrent detection system can be used.
FIG. 3A illustrates an example of the output of the overcurrent detection system of FIG. 2A.
FIG. 3B illustrates an example of the output of the overcurrent detection system of FIG. 2B.
FIG. 4A is a schematic drawing of an example of portions of an overcurrent detection system and an example of portions of an environment in which the overcurrent detection system can be used.
FIG. 4B is a schematic drawing of an example of portions of an overcurrent detection system and an example of portions of an environment in which the overcurrent detection system can be used.
FIG. 5 is a diagram of a method for operating portions of an overcurrent detection system.
FIG. 6 is a block diagram illustrating an example of a machine upon which one or more examples may be implemented.

### DETAILED DESCRIPTION

An electric vehicle can include an electric vehicle energy storage system. For example, a hybrid vehicle or an all-electric vehicle can include an electric vehicle energy storage system, such as can store energy that can be used to power the car. The electric vehicle energy storage system can include a chemical storage system, such as can include a battery system, a fuel cell system, or both.

An electric vehicle can include an overcurrent detection system, such as can be configured to detect an overcurrent condition in one or more portions of the electric vehicle, such as can include the electric vehicle energy storage system. For example, the overcurrent detection system can be configured to detect an overcurrent in the electric vehicle energy storage system (e.g., a main battery), such as due to a short circuit, an overload on a motor, etc. After detecting the overcurrent condition, the overcurrent detection system can isolate or otherwise disconnect one or more terminals of the electric vehicle energy storage system, such as by tripping a fuse. Determining a false negative overcurrent condition (e.g., declaring that no overcurrent condition is present when in fact there actually is an overcurrent condition present) can have one or more negative effects, such as can include damage to components (e.g., the electric vehicle energy storage system, a drive motor, other electric vehicle components), risk of fire (e.g., due to the electric vehicle energy storage system igniting), or both. To reduce the risk of a false negative, an overcurrent detection system that includes redundancy can be used. For example, two overcurrent detection circuits can be used to determine whether an overcurrent condition is present, and the fuse can be tripped if either overcurrent detection circuit determines that an overcurrent condition is present.

The present inventors have recognized, among other things, that disconnecting the electric vehicle energy storage system can disable one or more features of the electric vehicle, such as can include one or more of a drive system (e.g., a system configured to drive the wheels to move the car), a safety system (e.g., automatic braking, lane departure warning, etc.), a power steering system, etc. This can make tripping the fuse based on a false positive overcurrent condition determination undesirable. For example, if the fuse is tripped based on a false-positive overcurrent condition while a vehicle is on a highway, the people in the vehicle can be placed at risk of injury. Additionally, some fuses are single use (e.g., a pyrofuse), such as can require time and/or expense to replace.

The present inventors have recognized, among other things, that it can be desirable to reduce or otherwise adjust the likelihood of false positive overcurrent determinations in addition to reducing or otherwise adjusting the likelihood of false negative overcurrent determinations. In a system with two overcurrent detection circuits, for redundancy, the likelihood of a false negative can be reduced by requiring that only a single overcurrent detection circuit determines an overcurrent condition to trip the fuse, or the likelihood of a false positive can be reduced by requiring that both overcurrent detection circuits determine an overcurrent condition to trip the fuse. Thus, when two overcurrent detection circuits are provided, for redundancy, there is a tradeoff between handling false positives and handling false negatives.

The present inventors have recognized, among other things, that using three or more overcurrent detection circuits and voting circuitry configured to detect when two or more of the three or more overcurrent detection circuits are in a specified state (e.g., two or more overcurrent detection circuits are indicating an overcurrent condition, two or more overcurrent detection circuits are not indicating an overcurrent condition) can provide a level of redundancy against both a false positive and a false negative. For example, in an overcurrent detection system with three overcurrent detection circuits, if one of the overcurrent detection circuits determines a false positive or false negative result, while the remaining two circuits determine the correct result, the voting circuitry can determine the correct result by using voting, such as majority voting (e.g., the voting circuitry can output the indication given by two or more of the overcurrent detection circuits).

The present inventors have recognized, among other things, that the voting circuitry can provide a single point of failure, such as can cause a failure in the voting circuitry to determine a false positive or false negative. Redundant voting circuitry, such as can include first voting circuitry and second voting circuitry can be used.

Additional redundancy and/or checks can be used, such as can alert a user or circuit to one or more failures in one or more portions of the overcurrent detection system, such as before the one or more failures result in an incorrect output. Additional circuitry, such as can reduce a likelihood of common cause faults, can be used. For example, two or more of the overcurrent detection circuits can include their own clock source, their own voltage reference, or both. A common cause fault can include a fault that causes a false negative or false positive output if one or more of (1) a single component fails (e.g., a single resistor, capacitor, transistor, conductor, circuit trace, etc.), (2) a single circuit or portion of a circuit fails (e.g., a single overcurrent detection circuit, a single voting circuit, etc.), or (3) a single event and/or input that can affect more than one overcurrent detection circuit fails (e.g., a clock signal used by two or more circuits fails, a reference voltage used by two or more circuits deviates from a specified value, a voltage transient that affects two or more circuits). For example, a reference test circuit can be used to check that a reference voltage used by the overcurrent detection circuits is present and/or has a specified value, such as can help prevent a single point fault in the reference voltage causing a false negative of false positive output without alerting the user.

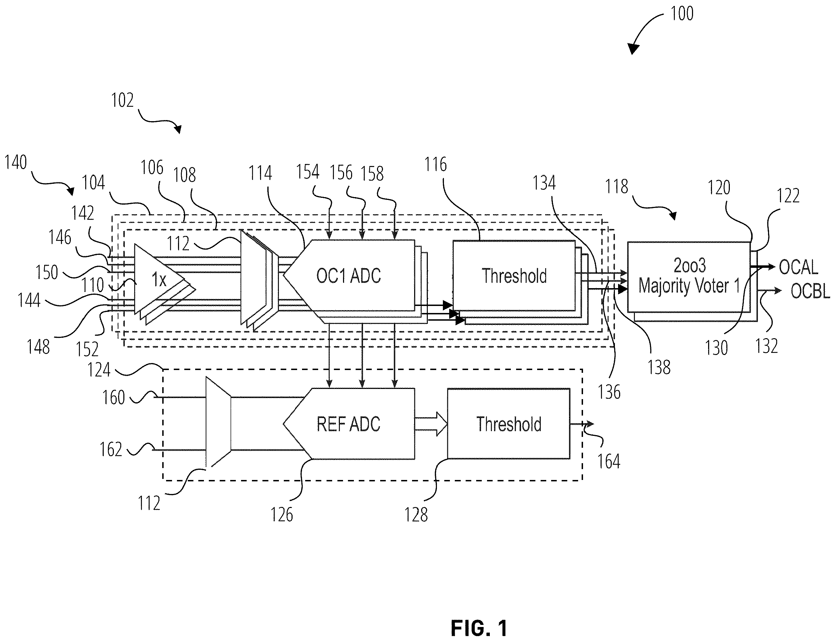

FIG. 1 is a schematic drawing of an example of portions of an overcurrent detection system 100. FIG. 1 shows that the overcurrent detection system 100 can include overcurrent detection circuits 102, such as can include a first overcurrent detection circuit 104, a second overcurrent detection circuit 106, and a third overcurrent detection circuit 108, and voting circuitries 118, such as can include first voting circuitry 120 and second voting circuitry 122. FIG. 1 shows that the overcurrent detection system 100 can receive one or more indications of a battery current value 140, such as on the first upper input node 142 and the first lower input node 144, the second upper input node 146 and the second lower input node 148, and the third upper input node 150 and third lower input node 152, and generate one or more voted overcurrent signals, such as the first voted overcurrent signal node 130 and the second voted overcurrent signal node 132.

FIG. 1 shows that the first overcurrent detection circuit 104 can include an amplifier 110, a test multiplexer 112, an analog-to-digital converter 114, and a threshold circuit 116. The first overcurrent detection circuit 104 can be configured to receive an input signal including an indication of a current value, and to generate an output signal indicating whether the current value exceeds a specified current threshold. The first overcurrent detection circuit 104 can be configured to receive an input signal on the first upper input node 142 and the first lower input node 144, such as can include a voltage between the first upper input node 142 and the first lower input node 144. This input signal can include an indication of a battery current value, such as can correspond to a battery or battery cell in an electric vehicle energy storage system. The indication of a battery current value can include a voltage generated across a shunt resistor arranged in series with the battery or battery cell.

The input signal can be amplified by an amplifier 110, such as can include increasing or decreasing an amplitude of the signal (e.g., doubling the signal value, halving the signal value), changing a current level (e.g., the amplifier 110 can have a large input impedance to avoid affecting a voltage across a shunt resistor and a low output resistance to provide current for downstream components), or otherwise filtering and/or stabilizing the input signal.

The signal from the amplifier 110 can be optionally passed through a test multiplexer 112 to an analog-to-digital converter 114. The analog-to-digital converter 114 can convert the analog signal received from the amplifier 110 to a digital representation of the input signal, such as can include generating a digital signal corresponding the voltage received by the analog-to-digital converter 114. The analog-to-digital converter 114 can be any style of analog-to-digital converter (ADC), such as can include a flash ADC, a successive approximation ADC, a sigma-delta ADC, an integrating ADC, etc.

The analog-to-digital converter 114 can receive a sampling clock signal on a sampling clock node 154, a reference voltage signal on a reference voltage node 156, and a signal ground voltage on a signal ground voltage node 158. The sampling clock signal can determine when the first overcurrent detection circuit 104 samples the indication of a battery current value. One or more of the reference voltage signal or the ground voltage can be used to determine the digital signal output by the analog-to-digital converter 114.

The digital output from the analog-to-digital converter 114, such as can correspond to the battery current value, can be passed to the threshold circuit 116. The threshold circuit 116 can include a comparator circuit that can be configured to compare the digital signal to a digital battery current threshold. The comparator circuit can include hysteresis, such as can prevent rapid switching between states. For example, if an overcurrent condition is detected at a specified value, the output of the comparator may not be reset until the input falls below the specified value by a hysteresis margin (e.g., a percent margin, such as 20 percent, a digital value, such as 100 arbitrary units, a voltage value, such as 100 millivolts). The digital battery current threshold can include a digital representation of the specified battery current threshold. The specified battery current threshold can include an overcurrent threshold (e.g., a maximum allowable battery current). The threshold circuit 116 can generate an overcurrent indication indicating whether the battery current value exceeds the specified battery current threshold (e.g., a digital high value indicates an overcurrent condition, a digital low value indicates the lack of an overcurrent condition). The overcurrent indication can be output from the first overcurrent detection circuit 104, such as on the first overcurrent indication node 134. In an example, the first overcurrent detection circuit 104 can determine the overcurrent indication using a historical current value alternatively or in addition to the instantaneous current value. For example, the first overcurrent detection circuit 104 can integrate a current value over a specified length of time, and compare the integrated value to a maximum integrated current value over the specified length of time, such as can approximate a heat build-up in one or more components (e.g., a conductor, a motor, a battery).

The test multiplexer 112 can be configured to provide a selected one of the input to the first overcurrent detection circuit 104 indicating the battery current value or a test signal value to the analog-to-digital converter 114. The test multiplexer 112 can allow the first overcurrent detection circuit 104 to be tested (e.g., testing that the first overcurrent detection circuit 104 indicates an overcurrent condition when receiving a voltage indicative of an overcurrent). In an example, the first overcurrent detection circuit 104 generates the overcurrent indication when the test multiplexer 112 is providing the test signal value to the analog-to-digital converter 114, such as can be due to the digital representation of the test signal value exceeding the digital battery current threshold. The first overcurrent detection circuit 104 can be tested one or more of on the initialization of the overcurrent detection system 100, on the startup of an electric vehicle, or recurrently (e.g., recurrently during operation). The test multiplexer 112 can connect the indication of a battery current value to the analog-to-digital converter 114 during a "normal operation" mode, such as can allow the analog-to-digital converter 114 to generate the digital signal corresponding to the indication of a battery current value. The test multiplexer 112 can connect a test signal value (e.g., a voltage, a current) to the analog-to-digital converter 114 during a "test" mode, such as can allow the analog-to-digital converter 114 to generate the digital signal corresponding to the test signal value.

The test multiplexer 112 can help to prevent the accumulation of single-point failures (SPFs) over time. For example, if one of three first overcurrent detection circuits 104 fails, the system can become non-redundant. However, without testing to determine that the overcurrent detection circuit has failed, a user or system may not know that the overcurrent detection system 100 is operating in a nonredundant state, and that the overcurrent detection system 100 is susceptible to single point faults (e.g., another overcurrent detection circuit failing can result in failure of the overcurrent detection system 100).

The second overcurrent detection circuit 106 and the third overcurrent detection circuit 108 can be configured similarly to the first overcurrent detection circuit 104, or one or more can differ in one or more ways. In an example, each of the first overcurrent detection circuit 104, the second overcurrent detection circuit 106, and the third overcurrent detection circuit 108 have their own input terminals, amplifier 110, test multiplexer 112, analog-to-digital converter 114, and threshold circuit 116, such as can reduce the likelihood of one or more common cause faults. In an example, the threshold circuits 116 are programmed and/or set independently for each of the overcurrent detection circuits. In an example, two or more of the first overcurrent detection circuit 104, the second overcurrent detection circuit 106, and the third overcurrent detection circuit 108 can share one or more components, such as input terminals. The second overcurrent detection circuit 106 can generate a second overcurrent indication on the second overcurrent indication node 136. The third overcurrent detection circuit 108 can generate a third overcurrent indication in the third overcurrent indication node 138.

The sampling time of one or more of the overcurrent detection circuits can be staggered, such as can include selecting the sampling time of one or more of the overcurrent detection circuits to reduce a likelihood of common cause faults, such as can include faults due to transient voltage or current spikes (e.g., due to electromagnetic interference, fast acceleration, hard braking, switching in a motor driver, other sources of transient noise, etc.). For example, the first overcurrent detection circuit 104, the second overcurrent detection circuit 106, and the third overcurrent detection circuit 108 can be configured to sample at different times. This can reduce the likelihood of common cause faults, such as can include a common cause fault due to a transient in one or more of the indication of a battery current value or the reference voltage.

One or more of the overcurrent detection circuits can include a latch function, which can latch the output to indicate that an overcurrent condition is detected after the detection of an overcurrent condition until the overcurrent detection circuit is reset, even if the overcurrent condition is no longer present. This can help to provide one or more of stability or reliability of the circuit, such as by providing the overcurrent indication to the one or more voting circuitries for a longer period of time than the overcurrent is present. The latch can be reset by the overcurrent detection system 100, such as after the output from the voting circuitries is determined. In an example, if only one of the overcurrent detection circuits detects an overcurrent condition, the overcurrent detection circuit may be reset after a specified period of time.

The first voting circuitry 120 can be configured to receive the respective overcurrent indications from one or more of the first overcurrent detection circuit 104, the second overcurrent detection circuit 106, and the third overcurrent detection circuit 108. The first voting circuitry 120 can be configured to generate a first voted overcurrent signal when at least two of the respective overcurrent indications indicate that the battery current value exceeds the specified battery current threshold. The first voted overcurrent signal can be used by the overcurrent detection system 100 and/or provided to one or more other circuits and/or systems, such as on the first voted overcurrent signal node 130. In an example, the first voting circuitry 120 can generate the first voted overcurrent signal only when at least two of the respective overcurrent indications indicate that the battery current value exceeds the specified battery current threshold.

The second voting circuitry 122 can be configured similarly to the first voting circuitry 120, or can differ in one or more ways. The second voting circuitry 122 can be configured to receive the respective overcurrent indications from one or more of the first overcurrent detection circuit 104, the second overcurrent detection circuit 106, and the third overcurrent detection circuit 108. The second voting circuitry 122 can be configured to generate a second voted overcurrent signal when at least two of the respective overcurrent indications indicate that the battery current value exceeds the specified battery current threshold. The second voted overcurrent signal can be used by the overcurrent detection system 100 and/or provided to one or more other circuits and/or systems, such as on the second voted overcurrent signal node 132.

The reference test circuit 124 can be configured to determine if the reference voltage and/or the signal ground voltage are within a specified range. The reference test circuit 124 can include a test multiplexer 112, a reference test ADC 126, and a reference test threshold circuit 128. The reference test circuit 124 can receive a measured, specified, or calibrated signal on the reference test upper input node 160 and the reference test lower input node 162, and can use the reference test ADC 126 to determine a digital representation of the received signal. The reference test ADC 126 can be affected by similar faults as the overcurrent detection circuits, such as because it can share one or more inputs, such as can include one or more of the sampling clock node 154, the reference voltage node 156, and the signal ground voltage node 158. In this way, the reference test ADC 126 can convert common-cause faults to one or more pieces of fault information that can be used by a user or circuit. In an example, the reference test ADC 126 can be constructed or operated similarly to the analog-to-digital converter 114, such as can include using the same or similar topology, or using the same conversion time. This can increase or otherwise alter the likelihood that the reference test ADC 126 generates fault information in response to a common cause fault occurring. The output from the reference test ADC 126 can be compared to a threshold value by the reference test threshold circuit 128, such as can generate a reference fault signal on the reference fault node 164. In an example, the reference test circuit 124 can provide a reference fault signal (e.g., a piece of fault information) in response to the received reference voltage not matching a specified reference voltage.

The fault output on the reference fault node 164 can be passed to one or more circuits along with the first voted overcurrent signal and the second voted overcurrent signal. If the fault output indicates that there is a fault in the overcurrent detection system 100, the circuit can temporarily ignore overcurrent indications, alter a reaction to the overcurrent indication in light of the fault information, or both. For example, the circuit may delay tripping a fuse for a specified length of time to see if the overcurrent detection system 100 can recover from the fault.

In an example, the fault output can be used to help prevent or respond to false negatives. For example, if one or the first overcurrent detection circuits 104 is determined to be not working properly, a user or circuit can be signaled, which can result in the user or circuit taking an action. For example, a vehicle can be put in a "limp" mode with limited range until the overcurrent detection system 100 can be serviced.

In an example, there can be more than three overcurrent detection circuits 102, such as can include four overcurrent detection circuits, five overcurrent detection circuits, or six or more overcurrent detection circuits. In an example, there can be more than two voting circuitries 118, such as can include three voting circuitries, or four or more voting circuitries. The voting circuitries can use a majority voting scheme (e.g., over half of the overcurrent indications must indicate an overcurrent condition is present to determine a voted overcurrent signal), or can require any number of overcurrent indications indicate that an overcurrent condition is present to determine a voted overcurrent signal. For example, requiring two out of four and/or two out of five can provide a level or redundancy to both false positives and false negatives.

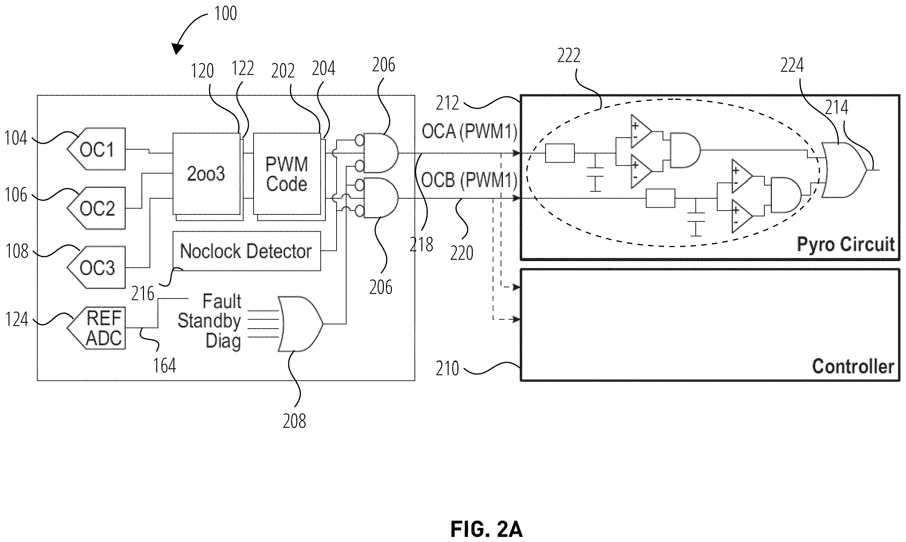

FIG. 2A is a schematic drawing of an example of portions of an overcurrent detection system 100 and an example of portions of an environment in which the overcurrent detection system 100 can be used. FIG. 2A shows that the overcurrent detection system 100 can also include first pulse width modulation (PWM) circuitry 202, second PWM circuitry 204, one or more AND gates 206, a no clock detector 216, and a system diagnostic OR gate 208.

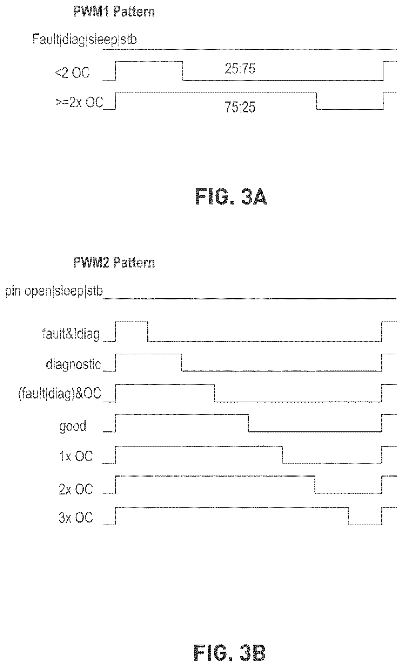

The first PWM circuitry 202 can receive the output of the first voting circuitry 120, and can be configured to generate a first PWM signal corresponding to the received signal, such as is further shown and described with respect to FIG. 3A. The second PWM circuitry 204 can receive the output of the second voting circuitry 122 and can be configured to generate a second PWM signal corresponding to the received signal. This first PWM signal can be output on the first PWM signal node 218. The second PWM signal can be output on the second PWM signal node 220. The respective PWM signals can include a signal of a specified frequency with a specified duty cycle (e.g., the signal is at a logical high level for the percentage of the signal period determined by the duty cycle, the signal is at a logical low level for the percentage of the signal period determined by the duty cycle). The frequency of the first PWM signal and the second PWM signal can take on any value, and can be the same or differ from the other. In an example, the frequency of one or more of the PWM signals can be 16 kilohertz.

The no clock detector 216 can be configured to determine if there is one or more of a missing clock signal, an error in the clock signal (e.g., improper signal form, improper voltage, improper frequency), or a fault with the clock signal. The no clock detector 216 can output a logical high value if a clock fault is determined.

The system diagnostic OR gate 208 can combine one or more system diagnostic signals, such as can include diagnostic, fault, error, or other information. For example, the system diagnostic OR gate 208 can receive the signal on the reference fault node 164, and combine this signal with one or more other signals. The system diagnostic OR gate 208 can output a logical high value if a fault is determined. The one or more system diagnostic signals can be generated by system diagnostic circuitry, such as can include the reference test circuit 124, the no clock detector 216, a standby detection circuit, or other diagnostic, fault, or error detection and/or determination circuit, such as can perform one or more system diagnostic functions.

The AND gates 206 can be configured to gate the output from the PWM encoders with the output of the no clock detector 216 and the system diagnostic OR gate 208. For example, if either of the no clock detector 216 or the system diagnostic OR gate 208 are indicating a fault (e.g., a logical high value), the output on the first PWM signal node 218 and the second PWM signal node 220 can be a constant logical low value. This can be used to signal to other circuits that the overcurrent detection system 100 is experiencing a fault.

FIG. 2A shows that the overcurrent detection system 100 can be used with control circuitry 210 and a fuse circuit 212. In the example of FIG. 2A, the fuse circuit 212 and the control circuitry 210 both receive the first PWM signal and the second PWM signal.

The fuse circuit 212 can include PWM decoding circuitry 222, a fuse circuit OR gate 224, and a fuse circuit output node 214. The PWM decoding circuitry 222 can be configured to turn the PWM signal received from the overcurrent detection system 100 into a digital signal, such as an include a digital signal indicative of the corresponding voted overcurrent signal. For example, the PWM decoding circuitry 222 can convert the signal received on the first PWM signal node 218 to a first digital signal and the signal received on the second PWM signal node 220 to a second digital signal, and pass the first and second digital signals to the fuse circuit OR gate 224. The fuse circuit OR gate 224 can generate a logical high value on the fuse circuit output node 214 if either of signal on the first PWM signal node 218 or the signal on the second PWM signal node 220 indicates an overcurrent condition. Following the fuse circuit OR gate 224, the system may not be redundant, such as can cause the system to be susceptible to common cause faults.

The signal on the fuse circuit output node 214 can be used to trip a fuse or other circuit isolating device (e.g., circuit breaker). The fuse can include a single use destructive fuse, such as a pyrofuse. A pyrofuse can have a fuse element that is configured to be melted when the fuse is tripped. A pyrofuse may be non-reversible, such as can include single use.

The control circuitry 210 can be configured to perform one or more functions, such as can include reporting an overcurrent condition to a user and/or adjusting one or more other circuits in response to an overcurrent condition. For example, the control circuitry 210 can put an electric vehicle into a limited function mode, or adjust and/or signal one or more other systems (e.g., an audio system, a cooling system, etc.). In an example, one or more of the control circuitry 210 or the fuse circuit 212 can be included in the overcurrent detection system 100.

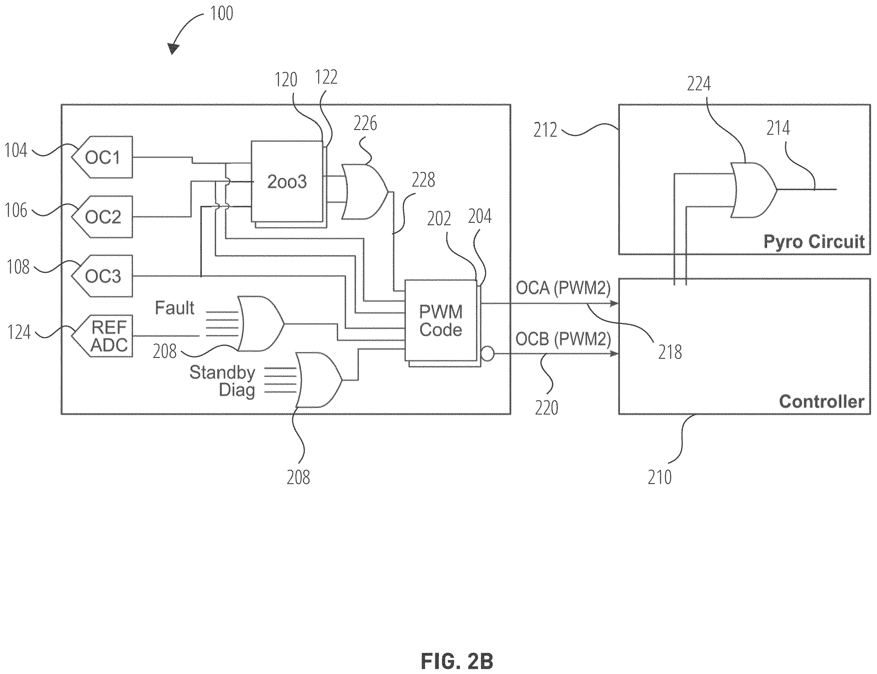

FIG. 2B is a schematic drawing of an example of portions of an overcurrent detection system 100 and an example of portions of an environment in which the overcurrent detection system 100 can be used. The overcurrent detection system 100 of FIG. 2B can include one or more similarities with the overcurrent detection system 100 of FIG. 2A. FIG. 2B shows that the first voted overcurrent signal can be combined with the second voted overcurrent signal in the voted overcurrent OR gate 226, and sent to redundant PWM encoders on the voted overcurrent signal node 228.

In the example of FIG. 2B, the first PWM circuitry 202 and the second PWM circuitry 204 can be configured to provide information on the first PWM signal node 218 and the second PWM signal node 220 respectively in addition to whether there is a fault, an overcurrent condition, or no overcurrent condition, such as is shown and described with respect to FIG. 3B. The PWM encoders can receive signals from one or more of the voted overcurrent OR gate 226, the first overcurrent detection circuit 104, the second overcurrent detection circuit 106, the third overcurrent detection circuit 108, and one or more system diagnostic OR gates 208.

The control circuitry 210 can receive the first PWM signal and the second PWM signal, and perform similar actions to the control circuitry 210 of FIG. 2A. Alternatively or in addition, the control circuitry 210 can decode the PWM signals to produce two digital signals indicative of the overcurrent condition to send to the fuse circuit 212. The fuse circuit 212 can pass these signals through the fuse circuit OR gate 224 to generate a signal on the fuse circuit output node 214 for controlling the fuse.

FIG. 3A illustrates an example of the output of the overcurrent detection system of FIG. 2A. FIG. 3A shows that the output on the first PWM signal node 218 and the second PWM signal node 220 can have three states, a fault state (e.g., a fault/diagnostic/sleep/standby state, such as can indicate one or more of a fault, a diagnostic indication, a sleep state, or a standby state) with a constant logical low value, a no overcurrent condition state with a duty cycle of 25 percent, and an overcurrent state with a duty cycle of 75 percent. The no overcurrent condition can be present when there are less than two overcurrent detection circuits indicating an overcurrent condition. The overcurrent condition can be present when there are more than two overcurrent detection circuits indicating an overcurrent condition. The duty cycles of the various states can take on any values that are distinct from the others.

FIG. 3B illustrates an example of the output of the overcurrent detection system of FIG. 2B. FIG. 3B shows that the output on the first PWM signal node 218 and the second PWM signal node 220 can have 7 states, including a fault state, a diagnostic state, a fault/diagnostic in addition to overcurrent condition state, a no overcurrent indication state, a single overcurrent indication state, a two overcurrent indication state, and a three overcurrent indication state.

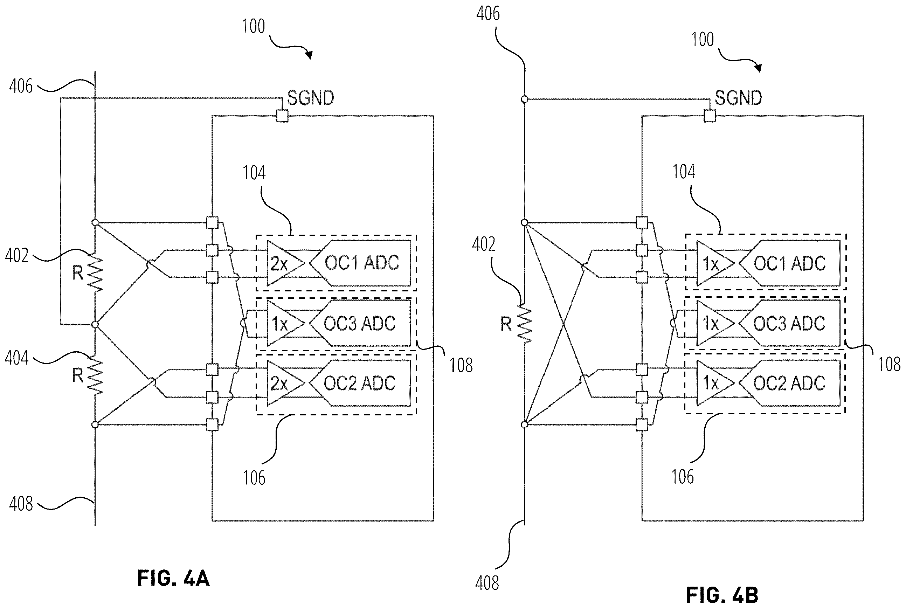

FIG. 4A is a schematic drawing of an example of portions of an overcurrent detection system 100 and an example of portions of an environment in which the overcurrent detection system 100 can be used. FIG. 4A shows an example of connecting an overcurrent detection system 100 to receive an indication of a battery current value. A first shunt resistor 402 and a second shunt resistor 404 can be arranged in series with an electric vehicle energy storage system, such as can include coupling between the first electric vehicle energy storage system connection 406 and the second electric vehicle energy storage system connection 408. A voltage generated across the shunt resistors can be proportional to a current through the shunt resistors, and can therefore be proportional to a current through the battery or battery cell.

In the example of FIG. 4A, the first overcurrent detection circuit 104 receives the voltage across the first shunt resistor 402, the second overcurrent detection circuit 106 receives the voltage across the second shunt resistor 404, and the third overcurrent detection circuit 108 receives the voltage across both the first shunt resistor 402 and the second shunt resistor 404.

FIG. 4B is a schematic drawing of an example of portions of an overcurrent detection system 100 and an example of portions of an environment in which the overcurrent detection system 100 can be used. FIG. 4B shows an example of an alternative method of connecting an overcurrent detection system 100 to receive an indication of a battery current value as compared to FIG. 4A. In the example of FIG. 4B, there may only be a first shunt resistor 402 and the first overcurrent detection circuit 104, the second overcurrent detection circuit 106, and the third overcurrent detection circuit 108 can all receive the voltage on the first shunt resistor 402.

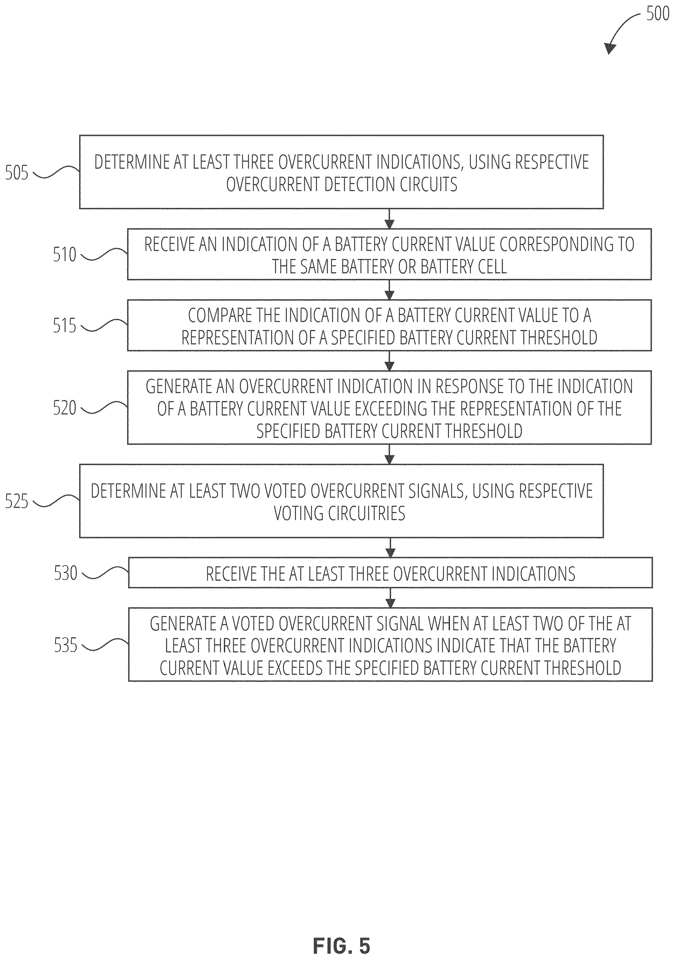

FIG. 5 is a diagram of a method 500 for operating portions of an overcurrent detection system 100. At step 505, at least three overcurrent indications can be determined, using respective overcurrent detection circuits. At step 510, determining each of the overcurrent indications can include receiving an indication of a battery current value corresponding to the same battery or battery cell. At step 515, determining each of the overcurrent indications can include comparing the indication of a battery current value to a representation of a specified battery current threshold. At step 520, determining each of the overcurrent indications can include generating an overcurrent indication in response to the indication of a battery current value exceeding the representation of the specified battery current threshold.

At step 525, at least two voted overcurrent signals can be determined, using respective voting circuitries. At step 530, determining each of the voted overcurrent signals can include receiving the at least three overcurrent indications. At step 535, determining each of the voted overcurrent signals can include generating a voted overcurrent signal when at least two of the at least three overcurrent indications indicate that the battery current value exceeds the specified battery current threshold. The shown order of steps is not intended to be a limitation on the order the steps are performed in. In an example, two or more steps may be performed simultaneously or at least partially concurrently.

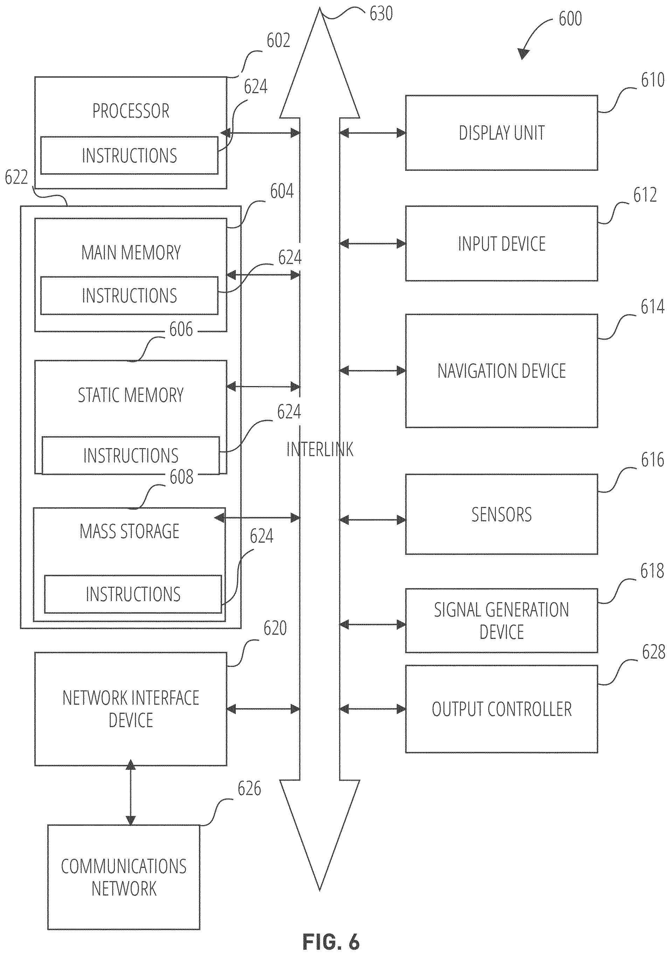

FIG. 6 illustrates a block diagram of an example machine 600 upon which any one or more of the techniques (e.g., methodologies) discussed herein may be implemented. Examples, as described herein, may include, or may operate by, logic or a number of components, or mechanisms in the machine 600. Circuitry (e.g., processing circuitry) is a collection of circuits implemented in tangible entities of the machine 600 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the machine 600 follow.

In alternative examples, the machine 600 may operate as a standalone device or may be connected (e.g., networked) to other machines. In a networked deployment, the machine 600 may operate in the capacity of a server machine, a client machine, or both in server-client network environments. In an example, the machine 600 may act as a peer machine in peer-to-peer (P2P) (or other distributed) network environment. The machine 600 may be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

The machine 600 may include a hardware processor 602 (e.g., a central processing unit (CPU), a graphics processing unit (GPU), a hardware processor core, or any combination thereof), a main memory 604, a static memory (e.g., memory or storage for firmware, microcode, a basic-input-output (BIOS), and mass storage 608 (e.g., hard drives, tape drives, flash storage, or other block devices) some or all of which may communicate with each other via an interlink 630 (e.g., bus). The machine 600 may further include a display unit 610, an alphanumeric input device 612 (e.g., a keyboard), and a user interface (UI) navigation device 614 (e.g., a mouse). In an example, the display unit 610, input device 612 and UI navigation device 614 may be a touch screen display. The machine 600 may additionally include a signal generation device 618 (e.g., a speaker), a network interface device 620, and one or more sensors 616, such as a global positioning system (GPS) sensor, compass, accelerometer, or other sensor. The machine 600 may include an output controller 628, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

Registers of the processor 602, the main memory 604, the static memory 606, or the mass storage 608 may be, or include, a machine readable medium 622 on which is stored one or more sets of data structures or instructions 624 (e.g., software) embodying or utilized by any one or more of the techniques or functions described herein. The instructions 624 may also reside, completely or at least partially, within any of registers of the processor 602, the main memory 604, the static memory 606, or the mass storage 608 during execution thereof by the machine 600. In an example, one or any combination of the hardware processor 602, the main memory 604, the static memory 606, or the mass storage 608 may constitute the machine readable media 622. While the machine readable medium 622 is illustrated as a single medium, the term "machine readable medium" may include a single medium or multiple media (e.g., a centralized or distributed database, and/or associated caches and servers) configured to store the one or more instructions 624.

The term "machine readable medium" may include any medium that is capable of storing, encoding, or carrying instructions for execution by the machine 600 and that cause the machine 600 to perform any one or more of the techniques of the present disclosure, or that is capable of storing, encoding or carrying data structures used by or associated with such instructions. Non-limiting machine readable medium examples may include solid-state memories, optical media, magnetic media, and signals (e.g., radio frequency signals, other photon based signals, sound signals, etc.). In an example, a non-transitory machine readable medium comprises a machine readable medium with a plurality of particles having invariant (e.g., rest) mass, and thus are compositions of matter. Accordingly, non-transitory machine-readable media are machine readable media that do not include transitory propagating signals. Specific examples of non-transitory machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; and CD-ROM and DVD-ROM disks.

In an example, information stored or otherwise provided on the machine readable medium 622 may be representative of the instructions 624, such as instructions 624 themselves or a format from which the instructions 624 may be derived. This format from which the instructions 624 may be derived may include source code, encoded instructions (e.g., in compressed or encrypted form), packaged instructions (e.g., split into multiple packages), or the like. The information representative of the instructions 624 in the machine readable medium 622 may be processed by processing circuitry into the instructions to implement any of the operations discussed herein. For example, deriving the instructions 624 from the information (e.g., processing by the processing circuitry) may include: compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions 624.

In an example, the derivation of the instructions 624 may include assembly, compilation, or interpretation of the information (e.g., by the processing circuitry) to create the instructions 624 from some intermediate or preprocessed format provided by the machine readable medium 622. The information, when provided in multiple parts, may be combined, unpacked, and modified to create the instructions 624. For example, the information may be in multiple compressed source code packages (or object code, or binary executable code, etc.) on one or several remote servers. The source code packages may be encrypted when in transit over a network and decrypted, uncompressed, assembled (e.g., linked) if necessary, and compiled or interpreted (e.g., into a library, stand-alone executable etc.) at a local machine, and executed by the local machine.

The instructions 624 may be further transmitted or received over a communications network 626 using a transmission medium via the network interface device 620 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), LoRa/LoRaWAN, or satellite communication networks, mobile telephone networks (e.g., cellular networks such as those complying with 3G, 4G LTE/LTE-A, or 5G standards), Plain Old Telephone (POTS) networks, and wireless data networks (e.g., Institute of Electrical and Electronics Engineers (IEEE) 602.11 family of standards known as Wi-Fi°, IEEE 602.15.4 family of standards, peer-to-peer (P2P) networks, among others. In an example, the network interface device 620 may include one or more physical jacks (e.g., Ethernet, coaxial, or phone jacks) or one or more antennas to connect to the communications network 626. In an example, the network interface device 620 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 600, and includes digital or analog communications signals or other intangible medium to facilitate communication of such software. A transmission medium is a machine-readable medium.

The present disclosure is believed to apply, at least in part, to any overcurrent detection system. For example, the battery or battery cell could be replaced with another energy storage system (e.g., a fuel cell), or could be replaced with another energy source, such as can include a generator (e.g., a gas generator, a power plant), a transformer, etc. For example, the overcurrent detection system 100 could be used to monitor for an overcurrent in a power plant.

The following, non-limiting examples, detail certain aspects of the present subject matter to solve the challenges and provide the benefits discussed herein, among others.

### Examples:

Example 1 is an overcurrent detection system for detecting an overcurrent in an electric vehicle energy storage system, the overcurrent detection system comprising: at least three overcurrent detection circuits, wherein each of the at least three overcurrent detection circuits is configured to receive an indication of a battery current value corresponding to the same battery or battery cell and is configured to independently generate a respective overcurrent indication when the battery current value exceeds a specified battery current threshold; first voting circuitry, configured to receive the respective overcurrent indications from the at least three overcurrent detection circuits and configured to generate a first voted overcurrent signal when at least two of the respective overcurrent indications indicate that the battery current value exceeds the specified battery current threshold; and second voting circuitry, configured to receive the respective overcurrent indications from the at least three overcurrent detection circuits and configured to generate a second voted overcurrent signal when at least two of the respective overcurrent indications indicate that the battery current value exceeds the specified battery current threshold.

In Example 2, the subject matter of Example 1 optionally includes wherein: the indication of a battery current value includes a voltage generated across a shunt resistor arranged in series with the battery or battery cell; and each of the at least three overcurrent detection circuits include: an analog-to-digital converter configured to generate a respective digital signal corresponding to a received voltage; and a threshold circuit configured to generate the respective overcurrent indication when the respective digital signal exceeds a respective digital battery current threshold corresponding to the specified battery current threshold.

In Example 3, the subject matter of any one or more of Examples 1-2 optionally include wherein: the indication of a battery current value for at least one of the overcurrent detection circuits includes a voltage across a shunt resistor that is distinct from a shunt resistor used to generate the indication of a battery current value for another one of the overcurrent detection circuits.

In Example 4, the subject matter of any one or more of Examples 2-3 optionally include wherein: a sampling time of at least two of the three analog-to-digital converters is selected to reduce a likelihood of common cause faults.

In Example 5, the subject matter of Example 4 optionally includes wherein: the sampling time of at least two of the three analog-to-digital converters is staggered.

In Example 6, the subject matter of any one or more of Examples 2-5 optionally include wherein: each of the at least three overcurrent detection circuits include: a test multiplexer, configured to: connect the indication of a battery current value to the analog-to-digital converter during a "normal operation" mode; and connect a test signal value to the analog-to-digital converter during a "test" mode.

In Example 7, the subject matter of Example 6 optionally includes wherein: the test signal value is configured such that the overcurrent detection circuits generates an overcurrent indication when the test multiplexer is providing the test signal value to the analog-to-digital converter.

In Example 8, the subject matter of any one or more of Examples 2-7 optionally include diagnostic circuitry, configured to generate an indication of one or more system diagnostic functions.

In Example 9, the subject matter of Example 8 optionally includes wherein: the diagnostic circuitry comprises a reference test circuit, configured to receive a reference voltage used by the three analog-to-digital converters and provide a reference fault signal in response to the received reference voltage not matching a specified reference voltage.

In Example 10, the subject matter of Example 9 optionally includes wherein: a circuit receiving the first voted overcurrent signal and the second voted overcurrent signal is configured to ignore an indicated overcurrent condition when the reference fault signal indicates that the reference voltage does not match the specified reference voltage.

In Example 11, the subject matter of any one or more of Examples 1-10 optionally include control circuitry, configured to: receive the first voted overcurrent signal and the second voted overcurrent signal; control a fuse, the fuse configured to disconnect the electric vehicle energy storage system; and trip the fuse to disconnect the electric vehicle energy storage system in response to at least one of the first voted overcurrent signal and the second voted overcurrent signal indicating an overcurrent condition.

Example 12 is an overcurrent detection system for detecting an overcurrent in an electric vehicle energy storage system, the overcurrent detection system comprising: at least three overcurrent detection circuits, wherein each of the at least three overcurrent detection circuits is configured to receive an indication of a battery current value corresponding to the same battery or battery cell and is configured to independently generate an overcurrent indication when the battery current value exceeds a specified battery current threshold; and first pulse width modulation (PWM) circuitry, configured to receive the respective overcurrent indications from the at least three overcurrent detection circuits and configured to generate a first PWM signal including an indication of a number of the respective overcurrent indications indicating that the battery current value exceeds the specified battery current threshold.

In Example 13, the subject matter of Example 12 optionally includes wherein: the indication of a battery current value includes a voltage generated across a shunt resistor arranged in series with the battery or battery cell; and each of the at least three overcurrent detection circuits include: an analog-to-digital converter configured to generate a respective digital signal corresponding to a received voltage; and a threshold circuit configured to generate the respective overcurrent indication when the respective digital signal exceeds a respective digital battery current threshold corresponding to the specified battery current threshold.

In Example 14, the subject matter of Example 13 optionally includes wherein: each of the at least three overcurrent detection circuits include: a test multiplexer, configured to: connect the indication of a battery current value to the analog-to-digital converter during a "normal operation" mode; and connect a test signal value to the analog-to-digital converter during a "test" mode.

In Example 15, the subject matter of any one or more of Examples 12-14 optionally include second PWM circuitry, configured to receive the respective overcurrent indications from the at least three overcurrent detection circuits and configured to generate a second PWM signal including an indication of a number of the respective overcurrent indications indicating that the battery current value exceeds the specified battery current threshold.

In Example 16, the subject matter of any one or more of Examples 12-15 optionally include diagnostic circuitry, configured to generate an indication of one or more system diagnostic functions.

In Example 17, the subject matter of Example 16 optionally includes wherein: the first PWM circuitry is configured to generate a first PWM signal including an indication of the one or more system diagnostic functions in addition to the indication of a number of respective overcurrent indications indicating that the battery current value exceeds the specified battery current threshold.

In Example 18, the subject matter of any one or more of Examples 15-17 optionally include control circuitry, configured to: receive the first PWM signal and the second PWM signal; control a fuse, the fuse configured to disconnect the electric vehicle energy storage system; and trip the fuse to disconnect the electric vehicle energy storage system in response to at least one of the first PWM signal and the second PWM signal indicating an overcurrent condition.

Example 19 is a method for detecting an overcurrent in an electric vehicle energy storage system, the method comprising: determining at least three overcurrent indications, using respective overcurrent detection circuits, wherein determining each of the at least three overcurrent indications includes: receiving an indication of a battery current value corresponding to the same battery or battery cell; comparing the indication of a battery current value to a representation of a specified battery current threshold; and generating an overcurrent indication in response to the indication of a battery current value exceeding the representation of the specified battery current threshold; and determining at least two voted overcurrent signals, using respective voting circuitries, wherein determining each of the at least two voted overcurrent signals includes: receiving the at least three overcurrent indications; and generating a voted overcurrent signal when at least two of the at least three overcurrent indications indicate that the battery current value exceeds the specified battery current threshold.

In Example 20, the subject matter of Example 19 optionally includes wherein: generating a voted overcurrent signal includes generating a pulse width modulation (PWM) signal including an indication of a number of the respective overcurrent indications indicating that the battery current value exceeds the specified battery current threshold.

Example 21 is at least one machine-readable medium including instructions that, when executed by processing circuitry, cause the processing circuitry to perform operations to implement of any of Examples 1-20.

Example 22 is an apparatus comprising means to implement of any of Examples 1-20.

Example 23 is a system to implement of any of Examples 1-20.

Example 24 is a method to implement of any of Examples 1-20.

Each of the non-limiting aspects above can stand on its own or can be combined in various permutations or combinations with one or more of the other aspects or other subject matter described in this document.

The above detailed description includes references to the accompanying drawings, which form a part of the detailed description. The drawings show, by way of illustration, specific examples that may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the terms "or" and "and/or" are used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The term "about," as used herein, means approximately, in the region of, roughly, or around. When the term "about" is used in conjunction with a numerical range, it modifies that range by extending the boundaries above and below the numerical values set forth. In general, the term "about" is used herein to modify a numerical value above and below the stated value by a variance of 10%. In one aspect, the term "about" means plus or minus 10% of the numerical value of the number with which it is being used. Therefore, about 50% means in the range of 45%-55%. Numerical ranges recited herein by endpoints include all numbers and fractions subsumed within that range (e.g., 1 to 5 includes 1, 1.5, 2, 2.75, 3, 3.90, 4, 4.24, and 5). Similarly, numerical ranges recited herein by endpoints include subranges subsumed within that range (e.g., 1 to 5 includes 1-1.5, 1.5-2, 2-2.75, 2.75-3, 3-3.90, 3.90-4, 4-4.24, 4.24-5, 2-5, 3-5, 1-4, and 2-4).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Such instructions can be read and executed by one or more processors to enable performance of operations comprising a method, for example. The instructions are in any suitable form, such as but not limited to source code, compiled code, interpreted code, executable code, static code, dynamic code, and the like.

Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other examples may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment. The scope of the examples should be determined with reference to the appended claims, along with the full scope of equivalents to which such claims are entitled.

## Claims

1. An overcurrent detection system for detecting an overcurrent in an electric vehicle energy storage system, the overcurrent detection system comprising:
at least three overcurrent detection circuits, wherein each of the at least three overcurrent detection circuits is configured to receive an indication of a battery current value corresponding to the same battery or battery cell and is configured to independently generate a respective overcurrent indication when the battery current value exceeds a specified battery current threshold;
first voting circuitry, configured to receive the respective overcurrent indications from the at least three overcurrent detection circuits and configured to generate a first voted overcurrent signal when at least two of the respective overcurrent indications indicate that the battery current value exceeds the specified battery current threshold; and
second voting circuitry, configured to receive the respective overcurrent indications from the at least three overcurrent detection circuits and configured to generate a second voted overcurrent signal when at least two of the respective overcurrent indications indicate that the battery current value exceeds the specified battery current threshold.

2. The overcurrent detection system of claim 1, wherein:
the indication of a battery current value includes a voltage generated across a shunt resistor arranged in series with the battery or battery cell; and
each of the at least three overcurrent detection circuits include:
an analog-to-digital converter configured to generate a respective digital signal corresponding to a received voltage; and
a threshold circuit configured to generate the respective overcurrent indication when the respective digital signal exceeds a respective digital battery current threshold corresponding to the specified battery current threshold.

3. The overcurrent detection system of claim 1 or 2, wherein:
the indication of a battery current value for at least one of the overcurrent detection circuits includes a voltage across a shunt resistor that is distinct from a shunt resistor used to generate the indication of a battery current value for another one of the overcurrent detection circuits.

4. The overcurrent detection system of claim 2 or 3, wherein:
a sampling time of at least two of the three analog-to-digital converters is selected to reduce a likelihood of common cause faults;
and wherein optionally the sampling time of at least two of the three analog-to-digital converters is staggered.

5. The overcurrent detection system of any one of claims 2 to 4, wherein:
each of the at least three overcurrent detection circuits include:
a test multiplexer, configured to:
connect the indication of a battery current value to the analog-to-digital converter during a "normal operation" mode; and
connect a test signal value to the analog-to-digital converter during a "test" mode;
and wherein optionally the test signal value is configured such that the overcurrent detection circuits generates an overcurrent indication when the test multiplexer is providing the test signal value to the analog-to-digital converter.

6. The overcurrent detection system of any one of claims 2 to 5, comprising:
diagnostic circuitry, configured to generate an indication of one or more system diagnostic functions.

7. The overcurrent detection system of claim 6, wherein:
the diagnostic circuitry comprises a reference test circuit, configured to receive a reference voltage used by the three analog-to-digital converters and provide a reference fault signal in response to the received reference voltage not matching a specified reference voltage;
and wherein optionally a circuit receiving the first voted overcurrent signal and the second voted overcurrent signal is configured to ignore an indicated overcurrent condition when the reference fault signal indicates that the reference voltage does not match the specified reference voltage.

8. The overcurrent detection system of any one of claims 1 to 7, comprising:
control circuitry, configured to:
receive the first voted overcurrent signal and the second voted overcurrent signal;
control a fuse, the fuse configured to disconnect the electric vehicle energy storage system; and
trip the fuse to disconnect the electric vehicle energy storage system in response to at least one of the first voted overcurrent signal and the second voted overcurrent signal indicating an overcurrent condition.

9. An overcurrent detection system for detecting an overcurrent in an electric vehicle energy storage system, the overcurrent detection system comprising:
at least three overcurrent detection circuits, wherein each of the at least three overcurrent detection circuits is configured to receive an indication of a battery current value corresponding to the same battery or battery cell and is configured to independently generate an overcurrent indication when the battery current value exceeds a specified battery current threshold; and
first pulse width modulation (PWM) circuitry, configured to receive the respective overcurrent indications from the at least three overcurrent detection circuits and configured to generate a first PWM signal including an indication of a number of the respective overcurrent indications indicating that the battery current value exceeds the specified battery current threshold.

10. The overcurrent detection system of claim 9, wherein:
the indication of a battery current value includes a voltage generated across a shunt resistor arranged in series with the battery or battery cell; and
each of the at least three overcurrent detection circuits include:
an analog-to-digital converter configured to generate a respective digital signal corresponding to a received voltage; and
a threshold circuit configured to generate the respective overcurrent indication when the respective digital signal exceeds a respective digital battery current threshold corresponding to the specified battery current threshold;
and wherein optionally:
each of the at least three overcurrent detection circuits include:
a test multiplexer, configured to:
connect the indication of a battery current value to the analog-to-digital converter during a "normal operation" mode; and
connect a test signal value to the analog-to-digital converter during a "test" mode.

11. The overcurrent detection system of any one of claims 9 or 10, comprising:
second PWM circuitry, configured to receive the respective overcurrent indications from the at least three overcurrent detection circuits and configured to generate a second PWM signal including an indication of a number of the respective overcurrent indications indicating that the battery current value exceeds the specified battery current threshold.

12. The overcurrent detection system of any one of claims 9 to 11, comprising:
diagnostic circuitry, configured to generate an indication of one or more system diagnostic functions;
wherein optionally
the first PWM circuitry is configured to generate a first PWM signal including an indication of the one or more system diagnostic functions in addition to the indication of a number of respective overcurrent indications indicating that the battery current value exceeds the specified battery current threshold.

13. The overcurrent detection system of any one of claims 11 or 12, comprising:
control circuitry, configured to:
receive the first PWM signal and the second PWM signal;
control a fuse, the fuse configured to disconnect the electric vehicle energy storage system; and
trip the fuse to disconnect the electric vehicle energy storage system in response to at least one of the first PWM signal and the second PWM signal indicating an overcurrent condition.

14. A method for detecting an overcurrent in an electric vehicle energy storage system, the method comprising:
determining at least three overcurrent indications, using respective overcurrent detection circuits, wherein determining each of the at least three overcurrent indications includes:
receiving an indication of a battery current value corresponding to the same battery or battery cell;
comparing the indication of a battery current value to a representation of a specified battery current threshold; and
generating an overcurrent indication in response to the indication of a battery current value exceeding the representation of the specified battery current threshold; and
determining at least two voted overcurrent signals, using respective voting circuitries, wherein determining each of the at least two voted overcurrent signals includes:
receiving the at least three overcurrent indications; and
generating a voted overcurrent signal when at least two of the at least three overcurrent indications indicate that the battery current value exceeds the specified battery current threshold.

15. The method of claim 14, wherein:
generating a voted overcurrent signal includes generating a pulse width modulation (PWM) signal including an indication of a number of the respective overcurrent indications indicating that the battery current value exceeds the specified battery current threshold.
